Europäisches Patentamt

European Patent Office

Office européen des brevets

(19)

(11) **EP 0 725 451 A1**

## (12) DEMANDE DE BREVET EUROPEEN

(43) Date de publication:
07.08.1996 Bulletin 1996/32

(51) Int Cl.$^6$: **H01L 41/09**

(21) Numéro de dépôt: **96400230.7**

(22) Date de dépôt: **02.02.1996**

(84) Etats contractants désignés:
**CH DE GB LI**

(30) Priorité: **06.02.1995 FR 9501330**

(71) Demandeurs:
• **THOMSON-CSF**
**75008 Paris (FR)**
• **CENTRE TECHNIQUE DE**
**L'INDUSTRIE HORLOGERIE "CETEHOR"**
**F-25003 BESANCON (FR)**

(72) Inventeurs:
• **Gaucher, Philippe**
**F-92402 Courbevoie Cedex (FR)**
• **Deljurie, Claude**
**F-92402 Courbevoie Cedex (FR)**
• **Duffait, Roland**
**F-92402 Courbevoie Cedex (FR)**
• **Bastien, François**
**F-92402 Courbevoie Cedex (FR)**
• **Manceau, Jean-François**
**F-92402 Courbevoie Cedex (FR)**

(54) **Transducteur en matériau à transformation électromécanique, application à des microactionneurs et procédé de réalisation**

(57)     L'invention concerne un transducteur à transformation électromécanique comprenant un empilement d'une plaque support en matériau conducteur (1), d'une couche de matériau à transformation électromécanique et d'une couche conductrice (3). La plaque (1) est en alliage de métal noble voire en métal noble ou est revêtue d'un tel métal. La couche de matériau à transformation électromécanique (2) est en contact direct (sans colle) avec la plaque support. Cette couche (2) présente des effets piézoélectriques ou électrostrictifs.

Selon un procédé de réalisation, la couche de matériau à transformation électromécanique est réalisée par un procédé de sérigraphie.

Application : Microactionneurs tels que moteurs piézoélectriques.

FIG.1

EP 0 725 451 A1

## Description

L'invention concerne un transducteur en matériau à transformation électromécanique, son application à des microactionneurs tels que des cantilevers ou des moteurs piézoélectriques. L'invention concerne également un procédé de réalisation de ces dispositifs.

Les céramiques piézoélectriques comme le PZT, le $BaTiO_3$ ou le PMNPT, ainsi que les céramiques électrostrictives comme le PLZT ou le PMN peuvent être utilisées pour créer des micro-déplacements de façon précise et rapide.

Cependant, comme ces matériaux sont très durs mécaniquement, leur déformation maximum n'excède pas quelques $10^{-4}$. Par contre, ils peuvent générer des contraintes mécaniques très élevées et par conséquent déformer d'autres matériaux plus élastiques comme des métaux ou du silicium.

Cet effet est mis à profit dans les actionneurs monomorphes où une plaque piézoélectrique est collée sur une plaque métallique pour amplifier la déformation de l'ensemble. Lorsque la céramique piézoélectrique est alimentée électriquement, elle tend à se déformer à la fois dans la direction parallèle au champ électrique (mode transverse caractérisé par le coefficients $k_{33}$ et $d_{33}$) et dans la direction perpendiculaire (mode longitudinal caractérisé par les coefficients $k_{31}$ et $d_{31}$). Le coefficient $k_{ij}$ caractérise le couplage, c'est-à-dire la conversion d'énergie potentielle électrique en énergie potentielle élastique. Le coefficient $d_{ij}$ caractérise la relation entre déformation S et le champ électrique E :

$$S_i = d_{ij}.E_j$$

Lorsque le facteur de forme de la céramique est favorable (faible épaisseur et grande surface), le mode longitudinal permet de générer dans la plaque support une contrainte élevée qui va tendre à la déformer de façon significative. Le moment élastique créé localement par une plaque actionneur de largeur b dépend en effet de son module élastique Ya, de son coefficient piézoélectrique da et de la tension Va appliquée à travers l'épaisseur ta de la céramique piézoélectrique :

$$Ma = (b.(ta + t).Ya). \frac{1}{(6+\Psi)} .da.Va$$

où t est l'épaisseur de la plaque support et $\Psi$ une constante.

On peut ainsi obtenir des déformations supérieurs à $10^{-2}$ avec une poutre encastrée (cantilever), la déformation étant alors le rapport entre le déplacement à extrémité de la poutre et la longueur de la poutre.

En particulier si la lame piézoélectrique est excitée à une fréquence qui correspond à un mode propre de la plaque support, la déformation est amplifiée d'un facteur $Q_m$ correspondant au facteur de qualité mécanique moyen du monomorphe.

Cet effet d'actionneur résonnant est aussi utilisé dans les moteurs piézoélectriques ou moteurs à ondes acoustiques pour la partie stator. Dans ce cas, on cherche à créer une onde de déformation élastique se propageant circulairement à la surface du stator pour entraîner par frottement un rotor prenant appui sur le stator.

On trouvera une description de tels moteurs dans le livre "Recherches en Microtechniques - Réalités et Perspectives" publié par l'Institut des Microtechniques et par CETEHOR dans la collection Livre Vert (France) page 103-109.

Actuellement, les actionneurs monomorphes, qu'ils soient du type cantilever ou circulaires, sont fabriqués par collage de céramiques massives sur une plaque métallique laminée. Les céramiques sont obtenues par le procédé classique de frittage de poudre à haute température suivi d'une métallisation obtenue par sérigraphie ou par dépôt sous vide.

Comme on veut obtenir une structure suffisamment compliante mécaniquement, il est nécessaire d'amincir la céramique à quelques centaines de microns pour un support de l'ordre du mm d'épaisseur. En effet la céramique est trop dure par rapport au support métallique déformable et augmente considérablement la rigidité de l'ensemble. Cet amincissement peut être fait par usinage ou par polissage, opérations coûteuses et délicates, et conduit à des céramiques fragiles et peu manipulables.

Dans le domaine de la miniaturisation, on ne peut guère descendre au-dessous du centimètre de diamètre pour le stator circulaire en raison de la précision de positionnement des céramiques nécessaires à la bonne excitation des modes.

Par ailleurs, le collage de céramiques massives est une opération délicate nécessitant une colle conductrice ayant une très grande rigidité mécanique. Une bonne liaison électrique est nécessaire pour alimenter la céramique piézoélectrique avec une tension relativement basse sans faire chuter le potentiel électrique dans une couche passive isolante. Une bonne liaison mécanique est également nécessaire pour coupler l'énergie élastique entre le piézoélectrique et le support et ne pas en dissiper ou en réfléchir à cause d'une liaison inadaptée.

Pour ces différentes raisons, par les technologies existantes, les valeurs de coefficient de couplage k ne dépassent pas 20 % pour les monomorphes de type cantilever et 10 % pour les stators circulaires, avec des facteurs de qualité mécanique $Q_m$ entre 100 et 1000.

L'invention concerne donc un transducteur à transformation électromécanique comprenant un empilement d'une plaque support en matériau conducteur, d'une couche de matériau à transformation électromécanique et d'une couche conductrice, caractérisé en ce que la plaque est en métal noble ou est revêtue d'un métal noble et en ce que la couche de matériau à transformation électromécanique est en contact direct avec la plaque support.

L'invention est applicable à un microactionneur comportant au moins une extrémité qui est immobilisée.

Elle est également applicable à un microactionneur circulaire tel qu'un micromoteur dans lequel la couche conductrice supérieure est réalisée sous forme de secteurs circulaires de façon à fournir le stator d'un moteur. Le rotor du moteur est situé du côté de la face de la plaque support ne portant pas la couche de matériau à transformation électromécanique et tournant par effet friction avec cette face de la plaque support.

L'invention concerne également un procédé de réalisation d'un transducteur à transformation électromécanique, caractérisé en ce qu'il comporte les étapes suivantes :

- réalisation d'une plaque support en métal noble ou revêtue d'un métal noble ;
- réalisation d'une couche d'un matériau à transformation électromécanique sur la plaque support ;
- cuisson de l'ensemble de façon à donner des propriétés électromécaniques au matériau de ladite couche ;
- réalisation sur la couche en matériau à transformation électromécanique d'une couche conductrice.

Les différents objets et caractéristiques de l'invention apparaîtront plus clairement dans la description qui va suivre et dans les figures annexées qui représentent :

- les figures 1 et 2, des exemples de réalisation simplifiés de dispositifs selon l'invention ;
- les figures 3 à 6, des courbes de fonctionnement des dispositifs en matériau piézoélectrique ;
- la figure 7, un exemple de réalisation collective de plusieurs stators pour moteurs piézoélectriques ;
- les figures 8a et 8b, des exemples de mesures de vibrations d'un stator de moteur piézoélectrique selon l'invention ;
- la figure 9, une courbe de fonctionnement du dispositif de l'invention.

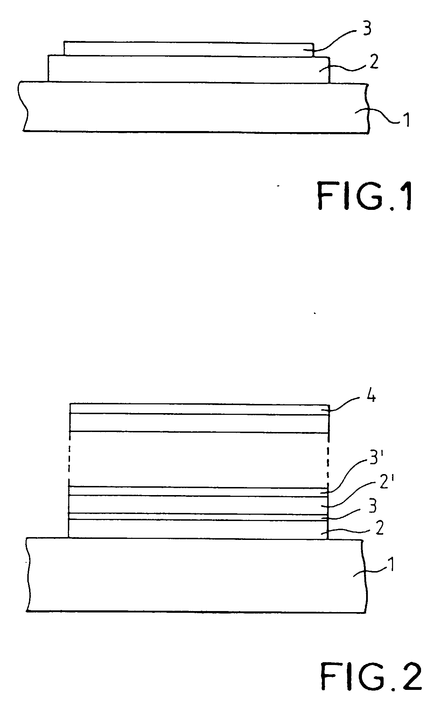

La figure 1 représente un exemple de réalisation simplifié d'un transducteur à transformation électromécanique selon l'invention.

Ce transducteur comporte une plaque support 1 en matériau inerte à haute température (par exemple 1000°C) en atmosphère oxydante tel qu'un métal noble ou un alliage à base de métal noble tel qu'un alliage de métal noble et d'un ou plusieurs métaux courants. Les métaux nobles utilisés peuvent être par exemple du platine, du palladium, du rhodium ou de l'irridium. La plaque support peut être aussi une plaque en métal courant revêtue de métal noble ou d'un alliage à base de métal noble. Le but est que cette plaque ne s'oxyde pas lors d'un traitement thermique à haute température. La plaque support 1 porte sur l'une de ses faces une couche 2 en matériau à transformation électromécanique. Par exemple, le matériau de cette couche est piézoélectrique ou électrostrictif. Cette couche 2 adhère à la plaque support 1 sans l'aide de matériau intermédiaire de collage. Elle est donc en contact direct avec la plaque. Enfin la couche 2 porte une couche conductrice 3 servant d'électrode.

La couche 2 est relativement mince (5 à 200 $\mu$m). Son épaisseur faible permet de la commander à l'aide d'une tension faible. En matériau électrostrictif elle peut être polarisée à l'aide d'une faible tension (10 Volts à quelques dizaines de Volts par exemple).

De plus, on démontre qu'on a intérêt de choisir le rapport de l'épaisseur e2 de la couche piézoélectrique 2 à l'épaisseur e1 de la plaque support dans une gamme telle que l'épaisseur e2 soit suffisante pour que l'effet piézoélectrique soit suffisant pour agir sur la plaque support 1. Il ne faut pas non plus que l'épaisseur e2 du piézoélectricité soit trop grande pour ne pas rigidifier la structure. C'est pourquoi, on choisit le rapport e2/e1 dans la gamme

$$1/3 \leq e2/e1 \leq 1/10$$

Un rapport judicieux serait d'environ 1/4.

Selon un exemple préféré de l'invention, la plaque support est en matériau ou en platine rhodié, ou bien en métal courant revêtu de platine ou de platine rhodié.

La figure 2 représente une variante de l'invention selon laquelle le transducteur comporte, sur la plaque support 1, un empilement de couches en matériau à transformation électromécanique 2, 2', ... et de couches conductrices en métal noble 3, 3', ... L'électrode supérieure 4 du dispositif peut être un métal noble ou métal courant. Un tel dispositif permet d'obtenir des effets mécaniques importants à l'aide de faibles tensions de commande.

Selon l'invention on utilise une technique de dépôt par sérigraphie pour déposer une couche piézoélectrique ou électrostrictive sur une plaque métallique en métal noble (platine ou alliage à base de platine), puis pour déposer l'électrode supérieure. Cette technique permet de réaliser des lames piézoélectriques de faible épaisseur (entre 5 et 200 $\mu$, voire entre 5 et 100 $\mu$m), qui sont denses et de bonne qualité, en contact intime avec le support métallique et qui sert à la fois de structure vibrante et d'électrode inférieure. Il n'y a donc pas besoin de phase étrangère pour assurer la liaison entre le matériau piézoélectrique et la plaque métallique 1. L'adhérence se faisant naturellement au moment du frittage de la couche sérigraphiée à haute température sous atmosphère oxydante. Cependant, pour d'autres résultats, on pourrait utiliser une autre technique que la sérigraphie.

La composition céramique utilisée pour réaliser l'encre de sérigraphie est de préférence une composition à basse température de frittage, comme celle décrite dans la Demande de Brevet français n° 94 01268 qui peut être frittée autour de 1000°C.

L'utilisation de métal noble pour le support est justifiée par le traitement de frittage en atmosphère oxydante (air ou oxygène pur) qu'aucun acier ou alliage conventionnel ne peut supporter en raison de l'oxydation rapide de ceux-ci. Cependant, on peut recouvrir un métal conventionnel d'une couche passivante de platine (par exemple déposée par pulvérisation cathodique ou par évaporation assistée par faisceau d'électrons) sur les deux faces pour isoler celui-ci de l'oxygène lors du frittage de la céramique.

Le procédé permet une réalisation collective puisqu'on peut sérigraphier plusieurs motifs de céramique et d'électrodes supérieures en même temps, et permet une miniaturisation plus poussée grâce à la résolution de la technique de sérigraphie et à la plus faible épaisseur d'éléments piézoélectriques que l'on peut obtenir.

On peut également étendre le procédé au dépôt multicouches en alternant au-dessus du support massif des dépôts de céramique et d'électrodes par la même technique de sérigraphie. Dans ce cas, les électrodes intermédiaires doivent être réalisées avec le même type de matériau (métal noble) que le support pour supporter les traitements oxydants de frittage des couches céramiques.

L'invention est applicable à la réalisation de cantilevers monomorphes.

Sur une lame de platine rhodié à 20 % de rhodium, d'épaisseur comprise entre 20 µm et 2 mm (quelques centaines de micromètres par exemple) on dépose une encre PMN-PZN-PT de composition 30/40/30 à travers un écran de sérigraphie. L'encre est réalisée à partir d'une poudre réalisée selon la Demande de Brevet français n° 94 01268 ou d'une poudre plus classique, mais ayant une température de frittage inférieure à 1200°C, par exemple par adjonction de fondants à base de bore et de silice. Dans ce dernier cas cependant, les performances piézoélectriques seront moins bonnes en raison de la présence de secondes phases non ferroélectriques.

La poudre, de granulométrie moyenne voisine de 2 micromètres, est ajoutée à raison de plus de 80% en poids à un mélange de solvants et de plastifiants connu dans l'art de la sérigraphie pour constituer une pâte de viscosité Brookfield de plusieurs milliers de centipoises. Le dépôt de cette pâte à travers un écran de 125 mesh permet de faire une couche d'épaisseur entre 10 et 100 micromètres selon le type d'écran.

La couche est séchée à 120°C, puis frittée à 1080°C dans un four de céramique conventionnel. On dépose ensuite par sérigraphie l'électrode supérieure de 5 micromètres d'épaisseur environ en argent dont le motif peut être différent de celui de la couche céramique. Cette électrode définit alors le condensateur plan qui servira de transducteur piézoélectrique pour faire vibrer la plaque.

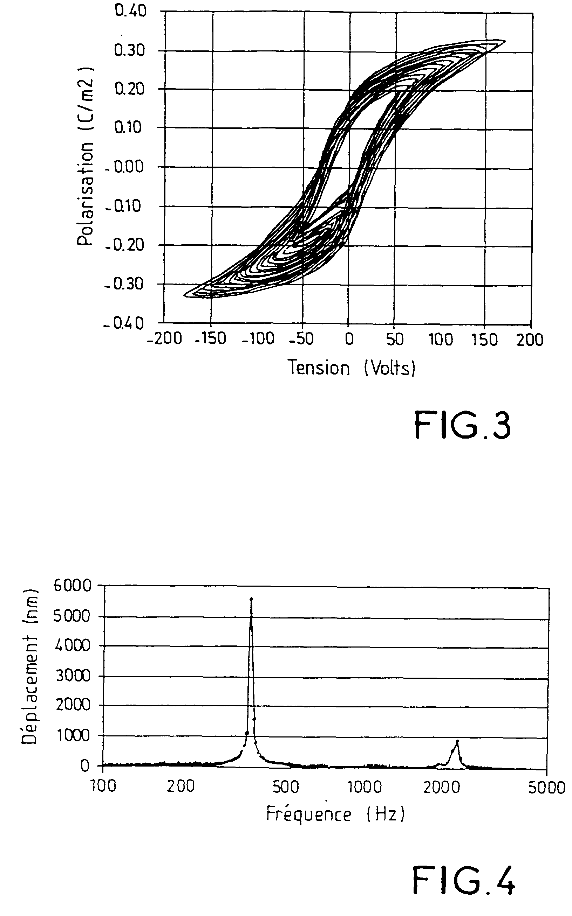

Les condensateurs ayant des compositions piézoélectriques sont polarisés par des méthodes classiques de polarisation de céramique piézoélectriques, soit à température ambiante en utilisant le cycle d'hystérésis comme montré à la figure 3, soit à haute température sous une tension continue correspondant à un champ électrique dans le matériau de l'ordre de 200 V/mm. La polarisation rémanente montrée par le cycle d'hystérésis est supérieure à $0,15 \text{ C/m}^2$, ce qui est largement suffisant pour rendre le matériau piézoélectrique.

Pour les compositions électrostrictives comme le PMN/PT 90/10, il suffit d'appliquer pendant le fonctionnement un champ continu d'environ 300 V/mm pour obtenir des effets électromécaniques au moins équivalents.

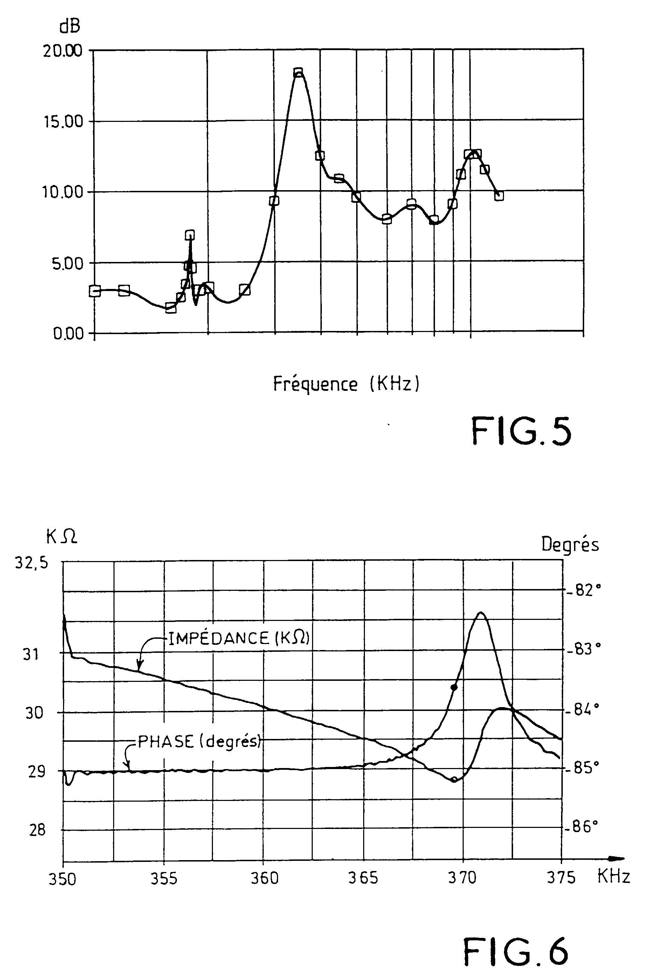

La figure 4 montre l'amplitude des vibrations modales que l'on peut générer en appliquant 1 Volt efficace sur la couche piézoélectrique de quelques $\text{mm}^2$ de surface. Le mode fondamental du cantilever à 370 Hz est excité à 15 dB au-dessus de la vibration forcée hors résonance (figure 5). Les modes d'ordre supérieur sont également excités.

La résonance électromécanique du monomorphe est visualisée à la figure 6 lorsque l'on mesure l'impédance électrique et la phase du condensateur plan en fonction de la fréquence. La constante diélectrique relative du matériau loin de la résonance est supérieure à 3000 et les pertes diélectriques sont inférieure à 5%. Le coefficient de couplage peut être estimé égal à 33 % avec un facteur de qualité mécanique de 140 en utilisant les données de la résonance électromécanique (J.F. MANCEAU, F. BASTIEN et R. DUFFAIT, IEEE Ultrasonic symposium 1994, Cannes, France).

L'invention est également applicable à la réalisation d'un moteur à ondes acoustiques et notamment à la réalisation du stator d'un tel moteur.

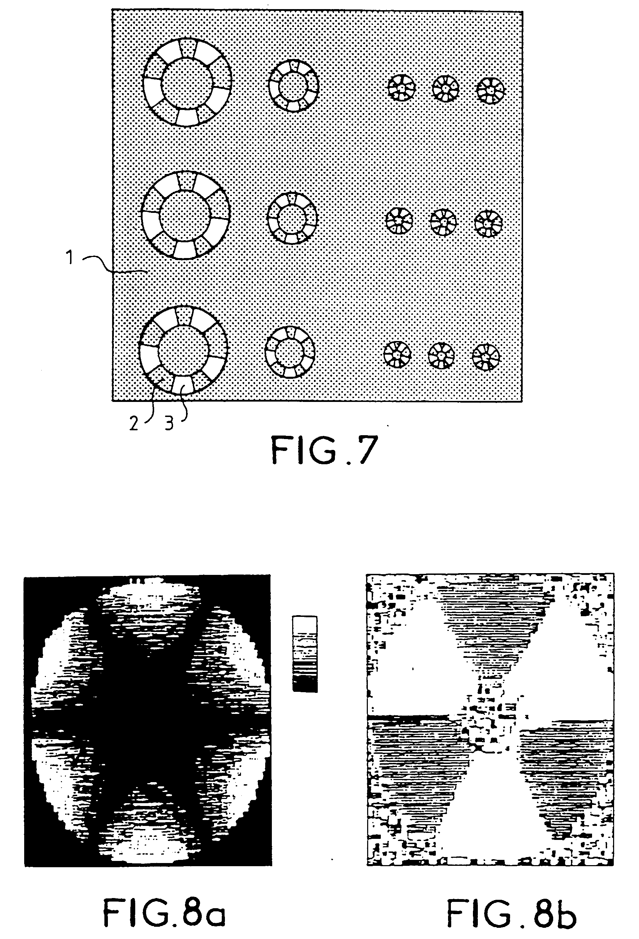

Des anneaux de céramique de taille comprise entre 1 et 5 mm sont sérigraphiés sur un support de platine rhodié de façon similaire à l'exemple précédent. Des électrodes en secteur en argent sont sérigraphiées après le frittage de la céramique selon un dessin permettant d'exciter deux modes de vibration de plaques circulaires déphasés de $\lambda/4$, où $\lambda$ est la longueur d'onde acoustique de chacun des modes. Le dispositif avant découpe est représenté par la figure 7.

Les stators sont ensuite découpés (en disques) et percés au centre pour faire passer un axe de rotation pour le rotor conformément à l'état de l'art des moteurs piézoélectriques réalisés par collage de céramiques.

Ensuite, il est possible d'usiner des dents, de symétrie radiale par rapport à l'axe de rotation, dans la face de chaque stator opposée à celle portant les anneaux en matériau piézoélectrique. Cela permet d'augmenter le rendement de conversion entre le stator et le rotor.

Sur cette figure 7, on voit des anneaux 2 en matériau piézoélectrique sur la plaque 1, et sur les anneaux 2 on voit les électrodes 3. Les anneaux de gauche ont 4,8 mm de diamètre, ceux du milieu ont 2,8 mm de diamètre et ceux de droite 1,5 mm de diamètre.

La polarisation des secteurs se fait de la même façon que dans l'exemple précédent. Pour les plus petits stators, un micromanipulateur sous points peut être utilisé, semblable à ceux utilisés en microélectronique.

L'amplitude et la phase de la vibration des stators, lorsqu'ils sont excités par les couches piézoélectriques, peut être visualisée à l'aide d'un interféromètre à sonde locale comme le montre les figures 8a et 8b. Dans l'exemple montré, c'est le mode d'ordre 3 qui est excité par une fréquence environ de 100 kHz. Le stator utilisé dans cet exemple est de 5 mm de diamètre et la plaque support en platine rhodié a une épaisseur de 60 μm.

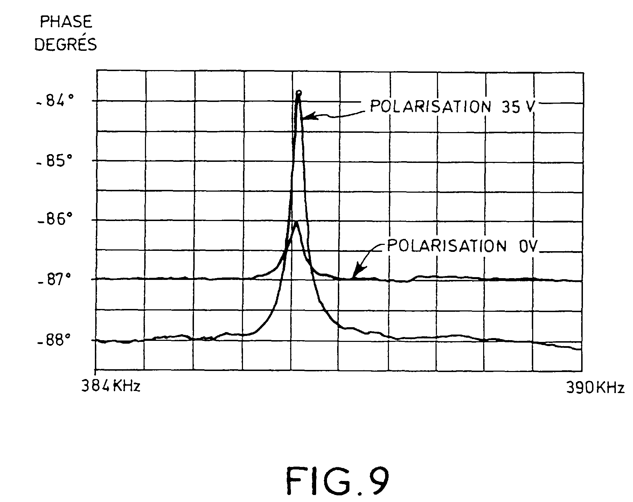

La résonance électromécanique du stator est visualisée à la figure 9. Le coefficient de couplage estimé est de l'ordre de 25 % avec un facteur de qualité mécanique de 1000. En appliquant une tension supplémentaire de polarisation continue de 35 V, on augmente considérablement l'amplitude de la résonance en raison des effets de polarisation induite qui s'ajoutent aux effets de polarisation rémanente. Le coefficient de couplage peut ainsi monter à 66 % (figure 9).

On remarque que dans certaines applications d'un tel moteur, un stator en platine ou alliage en platine est avantageux en raison de sa résistance à l'usure.

Les anneaux (2) de la figure 7 permettent ainsi de réaliser des microactionneurs dont la couche de matériau à transformation électromécanique (2) a la forme d'une couronne sur laquelle sont réalisés les secteurs circulaires de la couche conductrice (3).

La couronne peut être scindée en secteurs correspondants aux secteurs de la couche conductrice (3).

La face de la plaque support (1) ne portant pas la couche de matériau à transformation électromécanique comporte des dents d'entraînement orientées perpendiculairement au sens de rotation du rotor.

Dans le procédé de réalisation selon l'invention, la couche de matériau à transformation électromécanique (2) peut donc être réalisée sous forme d'une couronne circulaire sur laquelle sont réalisées les électrodes en forme de secteurs circulaires. De plus, la couche (2) elle-même peut être réalisée sous forme de secteurs circulaires correspondant aux électrodes en forme de secteurs.

Il est à noter également que selon le procédé de l'invention, la couche en matériau à transformation électromécanique obtenue après cuisson possède des propriétés piézoélectriques et qu'elle subit une polarisation sous haute tension.

**Revendications**

1. Transducteur à transformation électromécanique comprenant un empilement d'une plaque support en matériau conducteur (1), d'une couche de matériau à transformation électromécanique et d'une couche conductrice (3), caractérisé en ce que la plaque (1) est en alliage à base de métal noble, voire un métal noble, ou est revêtue d'un tel alliage ou d'un métal noble, et en ce que la couche de matériau à transformation électromécanique (2) est en contact direct avec la plaque support.

2. Transducteur selon la revendication 1, caractérisé en ce que la couche de matériau à transformation électromécanique (2) est en matériau piézoélectrique.

3. Transducteur selon la revendication 1, caractérisé en ce que la couche de matériau à transformation électromécanique (2) est en matériau électrostrictif.

4. Transducteur selon la revendication 1, caractérisé en ce que la couche à transformation électromécanique (2) a une épaisseur comprise entre 5 et 200 μm;

5. Transducteur selon la revendication 1, caractérisé en ce que la plaque support (1) a une épaisseur comprise entre 20 μm et 2 mm.

6. Transducteur selon la revendication 1, caractérisé en ce que le métal noble est du platine ou un alliage de platine rhodié.

7. Transducteur selon la revendication 1, caractérisé en ce que la plaque (4) est à base de cuivre revêtue de platine ou d'un alliage de platine rhodié.

8. Transducteur selon la revendication 1, caractérisé en ce que la couche conductrice (3) est en métal noble et en ce qu'il comporte une empilement de couches (2, 2' ...) en matériau piézoélectrique et de couches en métal noble (3, 3', ...).

9. Transducteur selon la revendication 1, caractérisé en ce que le rapport de l'épaisseur (e2) de la couche de matériau à transformation électromécanique à celle (e1) de la plaque support est compris entre 1/3 et 1/10.

10. Microactionneur appliquant le transducteur selon l'une quelconque des revendications précédentes, caractérisé en ce qu'il comporte au moins une extrémité immobilisée.

11. Microactionneur appliquant le transducteur selon l'une quelconque des revendications précédentes, caractérisé en ce qu'au moins la couche conductrice (3) est réalisée sous forme de secteurs circulaires de façon à fournir le stator d'un moteur, le rotor du moteur étant situé du côté de la face de la plaque support (1) ne portant pas la couche de matériau à transformation électromécanique (2) et tournant par effet friction avec cette face de la plaque support (1).

12. Microactionneur selon la revendication 11, caractérisé en ce que la couche de matériau à transformation électromécanique (2) a la forme d'une couronne sur laquelle sont réalisés les secteurs circulaires de la couche conductrice (3).

**13.** Microactionneur selon la revendication 12, caractérisé en ce que la couche de matériau à transformation électromécanique (2) de ladite couronne est scindée en secteurs correspondant aux secteurs de la couche conductrice (3).

**14.** Microactionneur selon la revendication 11, caractérisé en ce que la face de la plaque support (1) ne portant pas la couche de matériau à transformation électromécanique comporte des dents d'entraînement orientées perpendiculairement au sens de rotation du rotor.

**15.** Procédé de réalisation d'un transducteur à transformation électromécanique, caractérisé en ce qu'il comporte les étapes suivantes :

- réalisation d'une plaque support (1) en métal noble ou revêtue d'un métal noble ;
- réalisation d'une couche d'un matériau à transformation électromécanique (2) sur la plaque support (1) ;
- cuisson de l'ensemble de façon à donner des propriétés électromécaniques au matériau de ladite couche (2) ;
- réalisation sur la couche en matériau à transformation électromécanique d'une couche conductrice (3).

**16.** Procédé selon la revendication 15, caractérisé en ce que la couche en matériau à transformation électromécanique est réalisée par sérigraphie et que cette couche est séchée avant cuisson.

**17.** Procédé selon la revendication 15, caractérisé en ce que le matériau à transformation électromécanique obtenue après cuisson est un matériau destiné à acquérir des propriétés électrostrictives.

**18.** Procédé selon la revendication 15, caractérisé en ce que la couche en matériau à transformation électromécanique obtenue après cuisson possède des propriétés piézoélectriques et qu'elle subit une polarisation sous haute tension.

**19.** Procédé selon la revendication 15, caractérisé en ce que la couche à transformation électromécanique (2) a une épaisseur comprise entre 5 et 200 µm et la plaque support (1) a une épaisseur comprise entre 20 µm et 2 mm.

**20.** Procédé selon la revendication 15, caractérisé en ce que le métal noble est du platine ou du platine rhodié.

**21.** Procédé selon la revendication 15, caractérisé en ce que la couche conductrice (3) est réalisée sous forme d'électrodes en forme de secteurs circulaires de façon à constituer des électrodes d'excitation d'un stator d'un moteur.

**22.** Procédé selon la revendication 21, caractérisé en ce que la couche de matériau à transformation électromécanique (2) est réalisée sous forme d'une couronne circulaire sur laquelle sont réalisées les électrodes en forme de secteurs circulaires.

**23.** Procédé selon la revendication 22, caractérisé en ce que la couche de matériau à transformation électromécanique (2) est réalisée sous forme de secteurs circulaires correspondant sensiblement aux électrodes en forme de secteurs.

**24.** Procédé selon la revendication 15, caractérisé en ce que le matériau utilisé pour réaliser le matériau à transformation électromécanique est à base de PMN-PZN-PT.

FIG.1

FIG.2

FIG.3

FIG.4

Fréquence (KHz)

# FIG.5

# FIG.6

FIG.7

FIG.8a

FIG.8b

PHASE
DEGRÉS

POLARISATION 35 V

POLARISATION 0V

384 KHz                                        390 KHz

# FIG.9

**Office européen des brevets**

## RAPPORT DE RECHERCHE EUROPEENNE

Numéro de la demande

EP 96 40 0230

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP-A-0 629 007 (NGK INSULATORS LTD) 14 Décembre 1994<br>* page 8, ligne 56 - page 9, ligne 9 *<br>--- | 1 | H01L41/09 |
| X | EP-A-0 615 294 (NGK INSULATORS LTD) 14 Septembre 1994<br>* page 8, ligne 16 - ligne 31 *<br>--- | 1 | |
| X | WO-A-90 13149 (UNIV KINGSTON) 1 Novembre 1990<br>* page 10, ligne 9; revendication 12 *<br>--- | 1 | |
| A | DE-A-19 45 448 (SIEMENS AG) 11 Mars 1971<br>* page 3, ligne 8 - ligne 13 *<br>----- | 1 | |

**DOMAINES TECHNIQUES RECHERCHES (Int.Cl.6)**

H01L

Le présent rapport a été établi pour toutes les revendications

| Lieu de la recherche | Date d'achèvement de la recherche | Examinateur |
|---|---|---|
| LA HAYE | 9 Mai 1996 | Pelsers, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)